# EUROPÄISCHE PATENTSCHRIFT

(11) **EP 1 484 511 B1**
(45) Veröffentlichungstag und Bekanntmachung des Hinweises auf die Patenterteilung: **12.07.2006**
(21) Anmeldenummer: 03012971.2
(22) Anmeldetag: 07.06.2003
(51) Int. Cl.: F15B 13/00, H05K 7/14

(54) **Verkettungsmodul zur Ansteuerung eines elektrischen Ventilantriebs einer fluidtechnischen Ventilanordnung**
Chaining module in control of electrically actuating valve in fluid power control unit in Fluid power control device
Module d' un enchaînement contrôlant une valve actionnée électriquement dans un dispositif de commande fluidique

(43) Veröffentlichungstag der Anmeldung: 08.12.2004
(73) Patentinhaber: FESTO AG & Co, 73734 Esslingen (DE)
(72) Erfinder: Schauz, Stephan, 73312 Geislingen/Stg. (DE); Rohwer, Rolf, 73760 Ostfildern (DE); Suchy, Walter, 70176 Stuttgart (DE)
(74) Vertreter: Bregenzer, Michael

(56) Entgegenhaltungen:
- DE-A- 19 801 234
- DE-U- 29 724 594
- US-A- 4 956 747
- US-A- 5 495 871
- US-A1- 2002 112 765

## Beschreibung

Die Erfindung betrifft ein Verkettungsmodul, das mit weiteren verkettbar ist, mit einem Gehäuse und mit seitlichen Verkettungskontakten an dem Gehäuse zur elektrischen Kontaktierung mindestens eines weiteren Verkettungsmoduls.

Ein derartiges Verkettungsmodul ist beispielsweise aus der deutschen Patentschrift DE 19801234 C2 in Form einer pneumatischen Ventilbaugruppe bekannt. Auch andere batterieartig gekoppelte Anordnungen, z.B. speicherprogrammierbare Steuerungen oder dergleichen, können derartige Verkettungsmodule enthalten. Die aus der DE 19801234 C2 bekannten Ventilbaugruppen weisen eine scheibenartige Gestalt auf und können nebeneinander angeordnet werden. Oben auf pneumatischen Ventilanordnungen der Ventilbaugruppen sitzen Ventilantriebe, darüber die Verkettungskontakte und auf den Verkettungskontakten Decodier-Chips zur Steuerung der Ventilantriebe und zum Decodieren von Bussignalen, die über die Verkettungskontakte empfangen werden. Die Verkettungskontakte sind als federnde Kontaktfahnen, als starre Kontaktflächen oder als federbelastete Kontaktstifte ausgestaltet, die jeweils als separate Bauteile oben auf den Ventilbaugruppen angeordnet sind.

Der bekannte sandwichartige Aufbau ist für Umwelteinflüsse anfällig. Die sozusagen aufgesattelten Decodier-Chips und die Verkettungskontakte liegen frei, so dass es zu Beschädigung der Decodier-Chips und zur Oxidation und Verschmutzung der Verkettungskontakte kommen kann, wodurch die Betriebssicherheit der Ventilbatterie erheblich eingeschränkt ist.

Das US-Patent 5,495,871 beschreibt ein Verkettungsmodul, bei dem an einem Gehäuse Verkettungskontakte als männliche und weibliche Steckverbinder angeordnet sind. In den Gehäusen sind Steuerungs-Leiterplatinen angeordnet, die mit Hilfe eines Mehrfachsteckers an einen elektrischen Bus anschließbar sind. Durch Aneinanderstecken mehrerer Ventileinheiten kann eine Ventilbatterie gebildet werden.

Das US-Patent 4,956,747 betrifft ebenfalls ein Verkettungsmodul. Ein Gehäuse des Verkettungsmoduls enthält Federkontakte in der Art eines Kamms, an den weitere Komponenten des Modules angeschlossen sind. Die Federkontakte sind seitlich an den Modulen angeordnet, so dass sie bei Aneinanderreihung mehrerer Module miteinander in Kontakt treten. Die Metallfederkontakte haben Stecköffnungen, in die weitere, im Gehäuse des Verkettungsmodules angeordnete Komponenten, beispielsweise Leiterplatten, einsteckbar sind.

Es ist daher die Aufgabe der vorliegenden Erfindung, bei einem Verkettungsmodul der eingangs genannten Art eine kompakte, betriebssichere Bauweise zu erzielen.

Diese Aufgabe wird durch ein Verkettungsmodul gemäß der technischen Lehre des Anspruchs 1 gelöst. Zur Lösung der Aufgabe dienen ferner eine Modul-Einheit, insbesondere eine Ventilbaugruppe, sowie eine Batterie, insbesondere eine Ventilbatterie, die jeweils mindestens ein Verkettungsmodul der erfindungsgemäßen Art enthalten.

Das Verkettungsmodul integriert wesentliche Funktionen. Das als räumlicher Schaltungsträger ausgestaltete Gehäuse baut kompakt und erhöht die Betriebssicherheit, indem es ein Trägerelement für eine oder mehrere elektrische Komponenten bildet. Die Komponente(n) sind vorzugsweise geschützt im Innern des Verkettungsmoduls angeordnet. Die elektrische Komponente kann z.B. einen integrierten Steuerungs-Halbleiterbaustein, z.B. einen ASIC (= Application Specific Integrated Circuit), eine Leiterplatte, ein Schnittstellenbaustein für einen Kommunikationsbus oder dergleichen sein. Die Komponente kann z.B. eine Steuerungskomponente sein, die z.B. einen Ventilantrieb steuert und/oder überwacht.

Das Gehäuse des Verkettungsmoduls ist in der sogenannten MID-Technologie (MID = Moulded Interconnect Devices), also als spritzgegossener, räumlicher Schaltungsträger gefertigt. Der Schaltungsträger dient gleichzeitig als Gehäuse und als Leiterbahnträger.

Das Verkettungsmodul hat z.B. aufgedampfte und/oder galvanisch angebrachte und/oder durch Heißprägen aufgebrachte metallische Leiterbahnen.

Zweckmäßigerweise liegen beim batterieartig montierten Zustand der Verkettungsmodule die Verkettungskontakte flächig aneinander an. Somit ist die Austauschbarkeit des Verkettungsmoduls aus der Modul-Batterie verbessert. Prinzipiell könnten die Verkettungskontakte zumindest teilweise auch als Steckkontakte ausgestaltet sein.

Die Verkettungskontakte werden vorteilhaft durch das Gehäuse gebildet. Die Verkettungskontakte können auch einen integralen Bestandteil des Gehäuses bilden. Durch diese Maßnahmen wird die elektrische Betriebssicherheit verbessert.

Die Leiterbahnen des Verkettungsmoduls können teilweise auch durch ein integriertes, beispielsweise durch Spritzguss zumindest teilweise umschlossenes metallisches Stanz-Biegeteil gebildet werden. In den Schaltungsträger können beispielsweise ein oder mehrere Stanz-Biegeteile eingegossen sein. Es ist auch möglich, ein einstückiges Stanz-Biegeteil zunächst zu umspritzen und dann Verbindungsstege zwischen einzelnen Abschnitten des Stanz-Biegeteils nachträglich zu entfernen, wodurch eine elektrische Isolation der Abschnitte erzielt wird.

Die elektrischen Verkettungskontakte sind vorzugsweise bei montierter Ventilbatterie nach außen hin verdeckt. Somit werden Fehlkontakte, beispielsweise durch elektrischen Kurzschluss oder dergleichen, wirkungsvoll verhindert. Die Funktionssicherheit der Ventilbatterie wird verbessert.

Zweckmäßigerweise sind die Verkettungskontakte an gegenüberliegenden Seiten des Verkettungsmoduls angeordnet. Die Verkettungsmodule können auf diese Weise optimal aneinandergereiht werden. Jeweils ein Paar an gegenüberliegenden Seiten des Verkettungsmoduls angeordnete Verkettungskontakte sind zweckmäßigerweise einer Busleitung zugeordnet. Die im montierten Zustand aneinandergereihten Verkettungskontakte von zwei oder mehr erfindungsgemäßen Verkettungsmodulen bilden somit einen elektrischen Datenbus.

Die Verkettungskontakte sind vorteilhaft durch durchgehende Leiterbahnen miteinander verbunden. Die durchgehenden Leiterbahnen bilden zur Verringerung elektrischer Übergangswiderstände vorteilhafterweise Kontaktflächen der Verkettungskontakte. Diese Maßnahme dient einer optimalen Signalübertragungsqualität.

Die mindestens eine Komponente, z.B. eine Steuerungskomponente und/oder eine Kommunikationskomponente, ist zweckmäßigerweise an einer oder mehreren der durchgehenden, zwei oder mehr an gegenüberliegenden Seiten des Verkettungsmoduls angeordnete Verkettungskontakte verbindenden Leiterbahn angeordnet und mit dieser Leiterbahn elektrisch verbunden.

Das Verkettungsmodul weist vorteilhaft einen im montierten Zustand verschlossenen Aufnahmeraum für eine oder mehrere elektrische Komponenten, z.B. eine oder mehrere elektrische Leiterplatten, ASICs oder dergleichen, auf. Der Aufnahmeraum kann beispielsweise durch die am Verkettungsmodul montierte Modul-Einheit, das heißt durch deren Gehäuse, oder eine sonstige Abdeckung verschlossen sein. Vorzugsweise ist der Aufnahmeraum mit einer Vergussmasse ausgefüllt. Zweckmäßigerweise ist in dem Aufnahmeraum eine Tragstruktur für eine der elektrischen Komponenten vorgesehen. Die Tragstruktur befindet sich z.B. an einer Seitenwand des Verkettungsmodul-Gehäuses, die eine Gruppe von Verkettungskontakten aufweist. Zur Herstellung von elektrischen Verbindungen mit der elektrischen Komponente führen Leiterbahnen von den Verkettungskontakten zu der Tragstruktur. Die Signalwege von den Verkettungskontakten zu der elektrischen Komponente sind kurz.

An jeweils einer Seite des Verkettungsmoduls angeordnete Verkettungskontakte sind zweckmäßigerweise zu einem Kontaktbereich gruppiert. Bei diesem ist es bevorzugt, dass er durch ein nach außen abdichtendes Dichtungsmittel, z.B. eine umlaufende Gummi- oder Kunststoffdichtung, nach außen abgedichtet ist, wodurch beispielsweise eine Spritzwasserfestigkeit erzielt wird. Die Dichtungsmittel sind zweckmäßigerweise in das Gehäuse des Verkettungsmoduls integriert. Die Dichtungsmittel können durch das Gehäuse gebildet werden, das z.B. eine Dichtungsnutanordnung, elastische Bereich oder dergleichen aufweist. Somit sind die Verkettungskontakte gegen Umwelteinflüssen geschützt.

Bei den Verkettungskontakten sind verschiedene Bauarten bevorzugt:

Sie können als metallisierte Kunststoffglieder ausgeführt sein, die z.B. in der MID-Technologie gefertigt sind. Bevorzugt sind aber auch Metallfederkontakte, die beispielsweise durch ein metallisches Stanz-Biegeteil gebildet werden können. Eine weitere bevorzugte Variante sieht sogenannte Fuzz-Kontakte vor. Die Fuzz-Kontakte, auch Fuzzbuttons genannt, enthalten eine federnde Metallstruktur in der Art eines Knäuels aus dünnem Draht, die im kontaktierten Zustand am kooperierenden Verkettungskontakt eines benachbarten Verkettungsmoduls federnd anliegt. Die Metallstruktur besteht beispielsweise aus Berylliumkupferdraht, der außenseitig mit Gold beschichtet ist. Eine weitere Variante sieht vor, dass die Verkettungskontakte zumindest teilweise durch nicht-federnde elektrische Auflageflächen gebildet werden.

Zur elektrischen Verbindung der Verkettungskontakte benachbarter Verkettungsmodule können auch gegeneinander elektrisch isolierte, in einem elastischen Isolator, z.B. aus Silikon, angeordnete Leiter, z.B. aus feinem Golddraht, vorgesehen sein. Im montierten Zustand liegt der elektrische Isolator zwischen den benachbarten Verkettungsmodulen und die elektrischen Leiter verbinden die Verkettungskontakte der Verarbeitungsmodule miteinander, sind jedoch elektrisch voneinander isoliert.

Die Verkettungskontakte enthalten zweckmäßigerweise Kunststoffglieder. Die Kunststoffglieder sind z.B. durch eine metallische, insbesondere mit einem elektrisch nicht leitenden Überzug versehene Federanordnung mit mindestens einer Feder vorgespannt. Anstatt einer oder mehrerer Federn kann beispielsweise auch ein metallischer Federkamm verwendet werden. Insbesondere bei letzterer Variante ist der elektrisch nicht leitende Überzug zu einer elektrischen Isolierung der Verkettungskontakte voneinander bevorzugt. Die Kunststoffglieder sind beispielsweise an das Gehäuse des Verkettungsmoduls angespritzte federnde Zungen. Die Federanordnung bzw. der Federkamm ist z.B. ein Stanz-Biegeteil, das zwischen den federnden Zungen und einer Gehäusewand des Verkettungsmoduls angeordnet ist und die Federzungen in Richtung von dem Verkettungsmodul weg vorspannt. Dadurch wird auch bei einer eventuellen Ermüdung der metallisierten Kunststoffglieder eine optimale Kontaktsicherheit erzielt.

Es versteht sich, dass beliebige Kombinationen der vorgenannten Ausführungsformen der Verkettungskontakte bei einem erfindungsgemäßen Verkettungsmodul möglich sind.

Vorzugsweise weist das Verkettungsmodul Leuchtmittel zur Anzeige mindestens einer Funktion des Verkettungsmoduls, z.B. "Normalbetrieb" oder "Störung", auf. Die Leuchtmittel, bei denen es sich beispielsweise um LEDs handelt, sind zweckmäßigerweise geschützt im Innern des Verkettungsmoduls angeordnet, wobei Lichtleiter, z.B. aus transparentem Kunststoff, die von den Leuchtmitteln erzeugten Leuchtsignale zur Außenoberfläche des Verkettungsmoduls leiten. Die Leuchtmittel sind somit gegen Beschädigung oder Verschmutzung geschützt.

Eine weitere bevorzugte Variante der Erfindung sieht vor, dass die Verkettungskontakte im Wesentlichen durch eine im Zweikomponenten-Spritzgießverfahren hergestellte Trägerstruktur gebildet werden, und dass im Innern des Verkettungsmoduls eine Leiterbahnstruktur auf laseraktiviertem Material ausgebildet ist. Zwar sind beide Fertigungsverfahren in der MID-Technologie an sich bekannt. Durch die erfindungsgemäße Verknüpfung beider Fertigungsverfahren, die bei einem Verkettungsmodul für eine fluidtechnische Einrichtung der eingangs genannten Art an sich eine selbstständige Erfindung darstellt, wird eine optimale Kombination von mechanisch belastbaren Verkettungskontakten und feiner Struktur des Layouts innerhalb des Verkettungsmoduls erzielt. Beispielsweise besteht das Grund-Gehäuse des Verkettungsmoduls aus metallisierbarem Material, das mit einem laseraktivierbaren Material umspritzt wird. Das laseraktivierbare Material dient primär der Isolierung. Von dem metallisierbaren Material führen Leiterbahnen ins Innere des Verkettungsmoduls zu einer Fläche aus laseraktivierbarem Material, auf dem mittels eines Lasers Leiterbahnen aufgetragen werden.

Die folgenden Maßnahmen beziehen sich auf ein modulares Konzept, das an sich eine eigenständige Erfindung darstellt.

Das Verkettungsmodul ist vorteilhafterweise mit einer zu steuernden und/oder überwachenden Modul-Einheit verbindbar, wobei das Verkettungsmodul und die Modul-Einheit insgesamt ein Batteriemodul bilden, das mit weiteren Batteriemodulen zu einer Batterie koppelbar ist. Bei der Modul-Einheit handelt es sich beispielsweise um einen fluidtechnische, z.B. pneumatische Ventilanordnung und/oder einen Ventilantrieb für eine derartige Ventilanordnung und/oder eine Wartungseinheit und/oder eine Diagnoseeinheit. Die mindestens eine elektrische Komponente dient z.B. zur Steuerung und/oder Überwachung der Modul-Einheit und/oder für eine Kommunikation der Modul-Einheit und/oder des Verkettungsmoduls mit weiteren Batteriemodulen oder einer Steuerung, die die Batterie steuert und überwacht.

Im Falle der fluidtechnischen Modul-Einheit kann man das Batteriemodul auch als fluidtechnisches Batteriemodul bzw. als Ventilbaugruppe bezeichnen, die mit einer oder mehreren weiteren derartigen Ventilbaugruppen bzw. fluidtechnischen Batteriemodulen zu einer Ventilbatterie zusammenkoppelbar ist. Das Verkettungsmodul enthält zweckmäßigerweise einen elektrischen Ventilantrieb zur Betätigung der fluidtechnischen Ventilanordnung. Es ist auch möglich, dass das Verkettungsmodul Verbindungsmittel zu einer elektrischen Verbindung und Ansteuerung eines elektrischen Ventilantriebs aufweist. Der Ventilantrieb, der z.B. eine oder mehrere elektrodynamische oder elektrostatische Aktoren enthält, ist vorteilhaft ein separates Modul, das mit der Ventilanordnung und dem Verkettungsmodul koppelbar ist. Der Ventilantrieb kann auch in die Ventilanordnung integriert sein. Das Verkettungsmodul enthält zweckmäßigerweise eine Haltestromabsenkung für den Ventilantrieb und/oder Diagnosemittel für den Ventilantrieb und/oder für die ventilanordnung.

Die Ventilanordnungen bilden vorteilhaft im zur Ventilbatterie montierten Zustand einen durchgehenden Fluid-Versorgungskanal zur Fluid-Versorgung. Es ist auch möglich, dass die Ventilanordnung mit einem Fluid-Versorgungsmodul fluidtechnisch koppelbar ist. Das Fluid-Versorgungsmodul ist zur Versorgung der Ventilanordnungen mit Fluid vorgesehen. Das Fluid-Versorgungsmodul kann ein Trägerelement bilden, auf dem die Ventilbaugruppen bzw. fluidtechnischen Batteriemodule anordenbar sind.

Zweckmäßigerweise ist das Verkettungsmodul mit der Modul-Einheit fest, insbesondere stoffschlüssig, verbunden, beispielsweise verschweißt und/oder verklebt. Es versteht sich, dass auch andere Montagearten, beispielsweise Verschrauben oder dergleichen, möglich sind. Eine andere Variante der Erfindung sieht vor, dass das Verkettungsmodul lösbar mit der Modul-Einheit verbindbar ist. Bei einem Defekt der Modul-Einheit oder des Verkettungsmoduls kann eine der Komponenten leicht ausgetauscht werden.

Zur elektrischen Verbindung mit der Modul-Einheit sind vorteilhaft Verbindungsmittel, z.B. Steckverbindungsmittel, vorgesehen. Die Verbindungsmitteln können zweckmäßigerweise im montierten Zustand mit kooperierenden Verbindungsmitteln der Modul-Einheit mit einem Leitklebstoff verbunden sein. Der Leitklebstoff füllt z.B. einen zwischen den jeweiligen Verbindungsmitteln ansonsten vorhandenen Zwischenraum aus. Bei der Montage des Verkettungsmoduls sind die Verbindungsmittel noch verhältnismäßig lose, das heißt mit Spiel, ineinander gesteckt oder in sonstiger Weise nebeneinander angeordnet. Der Zwischenraum zwischen den Verbindungsmitteln ist mit dem noch flüssigen Leitklebstoff ausgefüllt, der nach dem Aushärten für eine kontaktsichere Verbindung der Verbindungsmittel sorgt. Insgesamt kann eine spannungsfreie Verbindung zwischen Verkettungsmodul und Ventilantrieb hergestellt werden.

Im Folgenden wird die Erfindung anhand mehrerer Ausführungsbeispiele unter Bezugnahme auf die Zeichnung näher erläutert. Es zeigen:
- Fig. 1: ein erstes Ausführungsbeispiel einer mit einem erfindungsgemäßen Verkettungsmodul versehenen Ventilbaugruppe,
- Fig. 2: eine Ventilbatterie mit mehreren aneinandergereihten Ventilbaugruppen gemäß Fig. 1,
- Fig. 3: eine Detailansicht des Verkettungsmoduls gemäß Fig. 1 von schräg unten, wobei die zum Ventilantrieb weisende Stirnfläche sichtbar ist,
- Fig. 4: ebenfalls das Verkettungsmodul gemäß Fig. 1 von schräg unten, wobei nicht-federnde Kontaktflächen sichtbar sind,
- Fig. 5: eine Variante des Verkettungsmoduls gemäß den vorgenannten Figuren von schräg unten mit einer auf einer Tragstruktur des Verkettungsmoduls aufliegenden Leiterplatte,
- Fig. 6: das Verkettungsmodul gemäß den vorigen Figuren von schräg unten mit einem angesetzten, teilweise geschnittenen Ventilantrieb,
- Fig. 7: das Verkettungsmodul und den Ventilantrieb in einer teilweise geschnittenen Ansicht, wobei das Verkettungsmodul etwa entlang einer Linie A-A in Fig. 1 gezeigt ist,
- Fig. 8: ein zweites Ausführungsbeispiel eines Verkettungsmoduls mit Metallfederkontakten,
- Fig. 9: ein Stanz-Biegeteil, das zur Bildung der Metallfederkontakte des Verkettungsmoduls gemäß Fig. 8 dient,
- Fig. 10: eine Seitenansicht des Verkettungsmoduls gemäß Fig. 8, wobei an den Verkettungskontakten angeordnete Beschriftungen sichtbar sind,
- Fig. 11: eine Ansicht des Verkettungsmoduls gemäß Fig. 8, bei der eine Leiterplatte (vgl. Figur 5) sowie weitere elektrische Komponenten aus Veranschaulichungsgründen weggelassen sind, so dass eine Tragstruktur mit elektrischen Kontakt-Pads für die Leiterplatte sichtbar ist,
- Fig. 12: ein drittes Ausführungsbeispiel eines erfindungsgemäßen Verkettungsmoduls mit Fuzz-Kontakten,
- Fig. 13: eine teilweise Schnittdarstellung des Verkettungsmoduls gemäß Fig. 12 entlang einer Linie B-B in Fig. 12, bei der der Aufbau eines Fuzz-Kontaktes schematisch dargestellt ist, und
- Fig. 14: eine schematisierte Vorderansicht von in einem elastischen Isolator angeordneten Leitern zur einer alternativen elektrischen Verbindung von nichtfedernden Verkettungskontakten eines Verkettungsmoduls, ähnlich etwa den Verkettungsmodulen gemäß Fig 11 und 12.

In der Zeichnung sind teilweise aus Gründen der Übersichtlichkeit einzelne Komponenten der erfindungsgemäßen Verkettungsmodule nicht dargestellt, beispielsweise Leiterbahnen, integrierte Schaltkreise oder dergleichen.

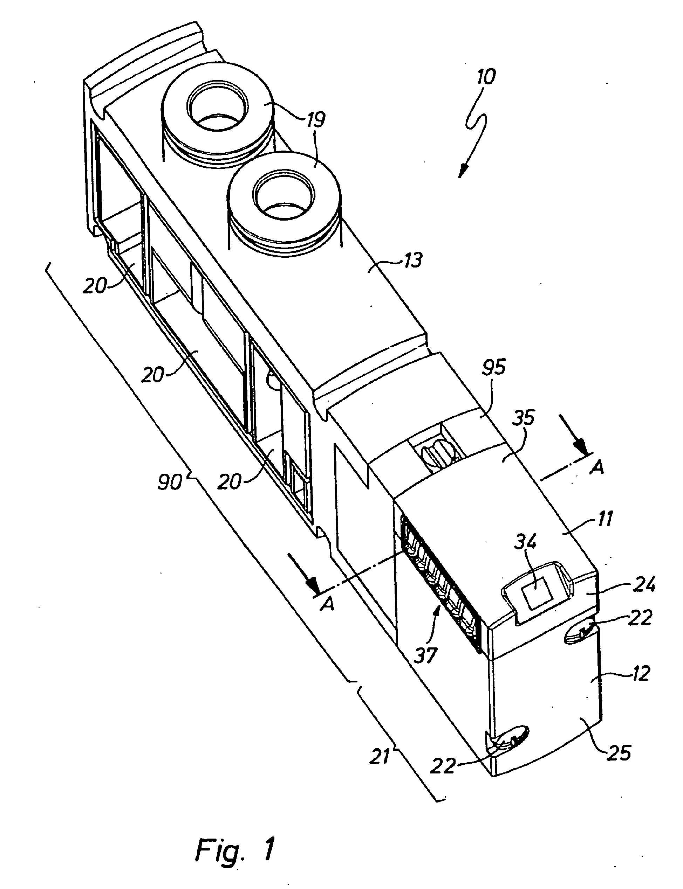

Die in Fig. 1 gezeigte Ventilbaugruppe 10 ist ein erfindungsgemäßes Batteriemodul, das nach einem erfindungsgemäßen modularen Konzept aufgebaut ist. Die Ventilbaugruppe 10 enthält eine Baueinheit 21 mit einem Verkettungsmodul 11, das vorliegend fest mit einem elektrischen Ventilantrieb 12 gekoppelt ist, und eine Modul-Einheit 90, die eine fluidtechnische Ventilanordnung 13 sowie eine Vorsteuerventileinheit 95 enthält. Die Baueinheit 21, mithin das Verkettungsmodul 11, ist mit der Modul-Einheit 90 lösbar verbunden. Das Verkettungsmodul 10 steuert den Ventilantrieb 12. Der Ventilantrieb 12 könnte lösbar mit dem Verkettungsmodul 10 verbunden sein. Der Ventilantrieb 12 könnt auch einen integralen Bestandteil des Verkettungsmoduls 10 bilden. Man könnte dann auch die Baueinheit 21 insgesamt als Verkettungsmodul bezeichnen.

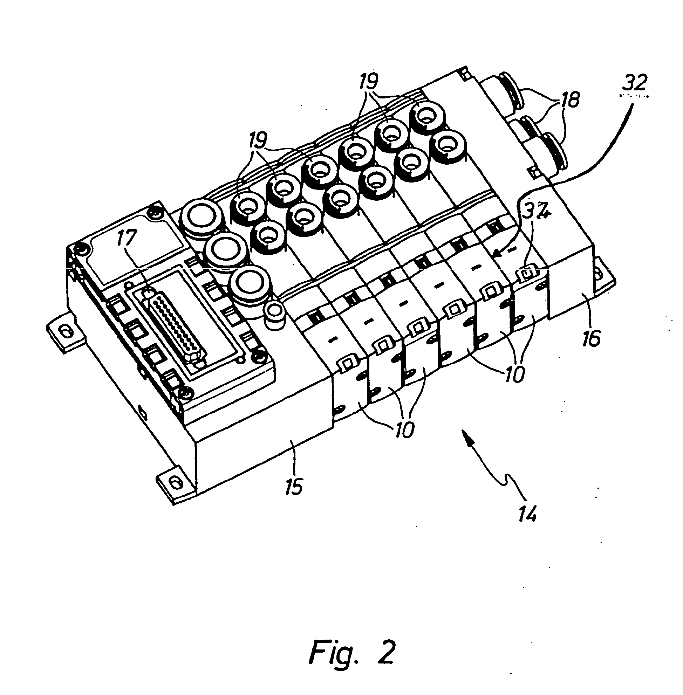

Mehrere Ventilbaugruppen 10 können als Module zu einer Ventilbatterie 14, also einer Modul-Batterie, zusammengefügt werden (Figur 2). Seitlich schließen Abschlussmodule 15, 16 die Ventilbatterie 14 ab. In dem Abschlussmodul 15 ist z.B. eine lokale Steuerungseinheit (nicht sichtbar) angeordnet, die über einen elektrischen Mehrfachkontakt 17 steuer- und überwachbar und/oder konfigurierbar ist. Am Abschlussmodul 16 befinden sich Anschlüsse 18 zur Versorgung der Ventilbaugruppen 10 mit einem Fluid, vorliegend Druckluft. Die lokale Steuerungseinheit steuert und/oder überwacht die Ventilbaugruppen 10 über einen Bus 32.

Durch Kanalabschnitte 20 der aneinandergereihten Ventilanordnungen 13 werden durchgehende Fluid-Versorgungskanäle gebildet, die über die Anschlüsse 18 mit Fluid versorgbar sind. Aus diesen kann Fluid durch Arbeitsanschlüsse 19, die vorn an der Ventilanordnung 13 angeordnet sind, in Abhängigkeit von einem in der Figur nicht sichtbaren Ventilglied der Ventilanordnung 13 strömen, das durch den Ventilantrieb 12 betätigbar ist. Der Ventilantrieb 12 kann ein direkt steuernder Ventilantrieb sein, das heißt, dass er das Ventilglied der Ventilanordnung 13 unmittelbar elektrisch betätigt. Der Ventilantrieb 12 kann auch fluidtechnische Vorsteuerventile enthalten, die elektrisch betätigbar sind. Vorliegend sind Vorsteuerventile in der Vorsteuerventileinheit 95 vorhanden, die durch den Ventilantrieb 12 betätigt werden. Prinzipiell ist jede Art elektrischer Betätigung bei dem Ventilantrieb 12 möglich, beispielsweise eine elektrodynamische und/oder eine elektrostatische Betätigung. Eine typische elektrodynamische Betätigung erfolgt z.B. durch Magnetspulen, eine elektrostatische Betätigung beispielsweise durch Piezo-Elemente.

Das Verkettungsmodul 11 und der Ventilantrieb 12 bilden eine modulare Baueinheit 21. Das Verkettungsmodul 11 sitzt beim Ausführungsbeispiel oben auf dem Ventilantrieb 12 und ist mit diesem stoffschlüssig, beispielsweise durch Verkleben und/oder durch Schweißen, insbesondere Ultraschallschweißen, verbunden. Die Baueinheit 21 ist seitlich an der Ventilanordnung 13 angeordnet, beispielsweise mit Schrauben 22 an eine Vorsteuerventileinheit 95 der Ventilanordnung 13 angeschraubt. Eine alternative Bauform der Baueinheit 21 könnte auch eine Vorsteuerventilanordnung enthalten. Die vordere Stirnseite 23 des Verkettungsmoduls 11 liegt vorliegend an der Ventilanordnung 13 an. Zusätzlich können Vorsprünge der Ventilanordnung 13 in Ausnehmungen des Verkettungsmoduls 11 und/oder des Ventilantriebs 12 eingreifen. Die Schrauben 22 sind von der hinteren Stirnseite 25 des Ventilantriebs 12 her, die mit der hinteren Stirnseite 24 des Verkettungsmoduls 11 ein im Wesentlichen plane Oberfläche bildet, durch den Ventilantrieb 12 hindurch gesteckt und in die Ventilanordnung 13 eingeschraubt. Es ist möglich, die Baueinheit 21 bei montierter Ventilbatterie 12 - gegebenenfalls nach vorheriger Lockerung eines in der Figur nicht dargestellten Zugankers - zu lösen. Ein Austausch defekter Komponenten ist möglich.

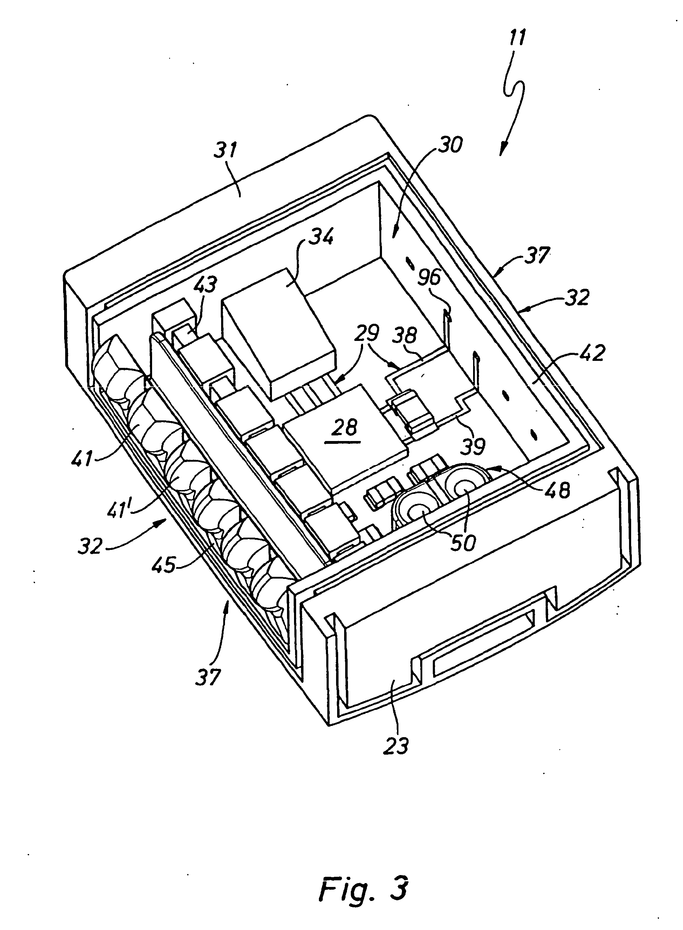

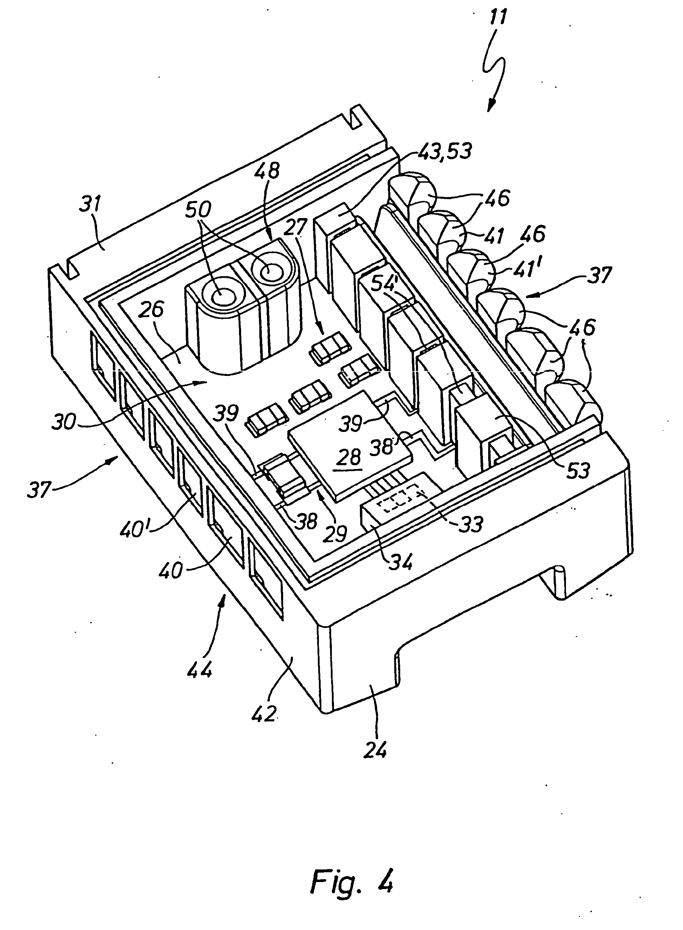

In den Fig. 3 und 4 ist das Verkettungsmodul 11 schräg von unten dargestellt, wobei sein Aufnahmeraum 26 für elektrische Komponenten, z.B. Steuerungskomponenten 27 sichtbar ist. Die Steuerungskomponenten 27, z.B. Kondensatoren, Widerstände sowie insbesondere ein Steuerungs-Halbleiterbaustein 28, sind unmittelbar an nur teilweise dargestellten Leiterbahnen 29 des Verkettungsmoduls 11 angeordnet, dessen Gehäuse 31 als Schaltungsträger 30 dient. Der Steuerungs-Halbleiterbaustein 28, im Folgenden kurz "Chip 28" genannt, steuert und überwacht die Funktionen des Ventilantriebs 12. Ferner dient der Steuerungs-Halbleiterbaustein 28, der z.B. ein ASIC ist, zur Kommunikation mit benachbarten Ventilbaugruppen 10 und/oder der lokalen Steuerungseinheit im Abschlussmodul 15. Der Chip 28 enthält beispielsweise eine Busschnittstelle sowie Ein- und Ausgabeschnittstellen. Im vorliegenden Fall ist in den Chip 28 auch eine Haltestromabsenkung für den Ventilantrieb 12 integriert. Ferner kann er die Funktionsweise des Ventilantriebs 12 sowie der Ventilanordnung 13 diagnostizieren und die korrekte Funktion oder Fehlfunktionen der Komponenten 12, 13 melden. Beispielsweise sendet der Chip 28 entsprechende Meldetelegramme über den Bus 32, der durch aneinanderliegende Verkettungskontakte 37 der Verkettungsmodule 11 gebildet wird, an die zentrale Steuerung im Abschlussmodul 15.

Ferner zeigt das Verkettungsmodul 11 aktuelle Diagnoseparameter optisch an. Hierfür steuert der Chip 28, bei dem es sich beispielsweise um einen ASIC oder einen Mikro-Controller handelt, Leuchtmittel 33, z.B. LEDs in verschiedenen Farben, an, die ebenfalls an den Leiterbahnen 29 angeordnet sind. Die Leuchtmittel 33 sind so wie die übrigen Steuerungskomponenten 27 beispielsweise mit den Leiterbahnen 29 verlötet oder in sonstiger Weise elektrisch verbunden. Vorliegend handelt es sich bei diesen Komponenten um sogenannte SMD-Bauteile (Surface Mounted Devices), die eine besonders kompakte Bauweise ermöglichen. Die Leuchtmittel 33 sind geschützt im Aufnahmeraum 26 angeordnet. Von ihnen erzeugte Lichtsignale leitet ein Lichtleiter 34, beispielsweise ein transparenter Kunststoff, zur Außenoberfläche des Verkettungsmoduls 11. Der Lichtleiter 34 hat eine schräge Außenoberfläche und schließt mit einer Ausnehmung 36 im Wesentlichen plan ab, die schräg zwischen der Stirnseite 24 und der Oberseite 35 des Verkettungsmoduls 11 verläuft. Somit sind die Lichtsignale der Leuchtmittel 33 auch bei in der Ventilbatterie 14 montiertem Verkettungsmodul 11 von oben und von der Seite her gut erkennbar.

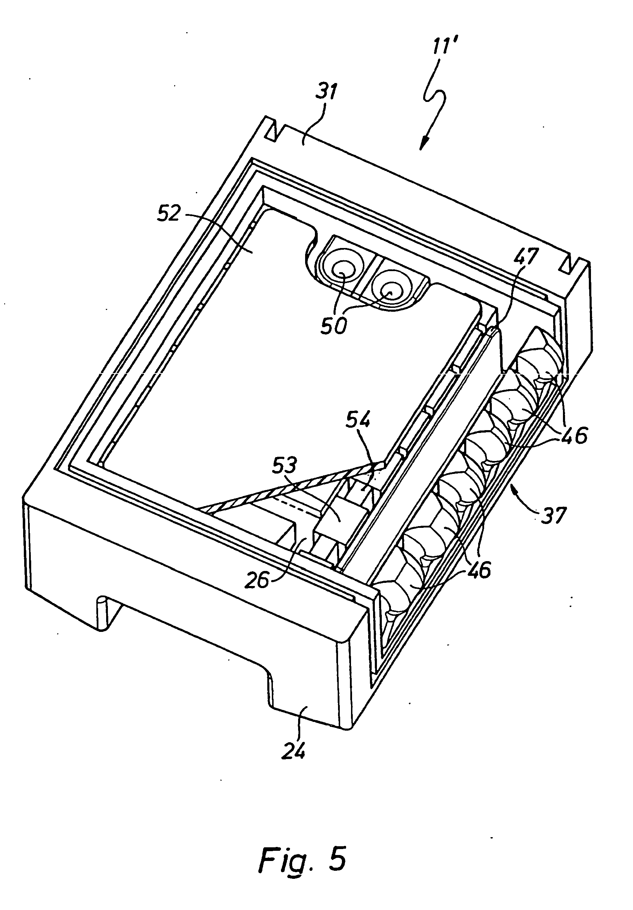

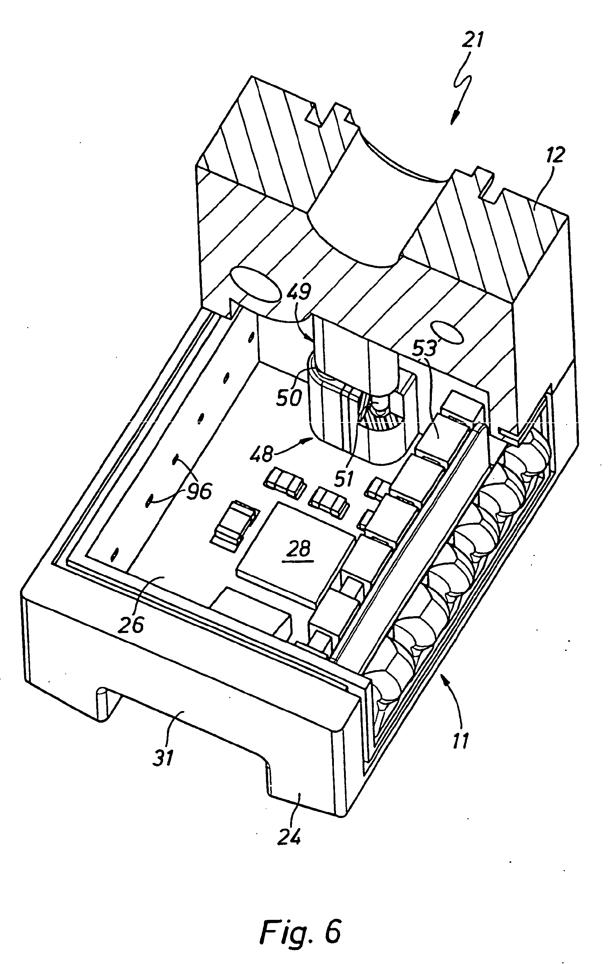

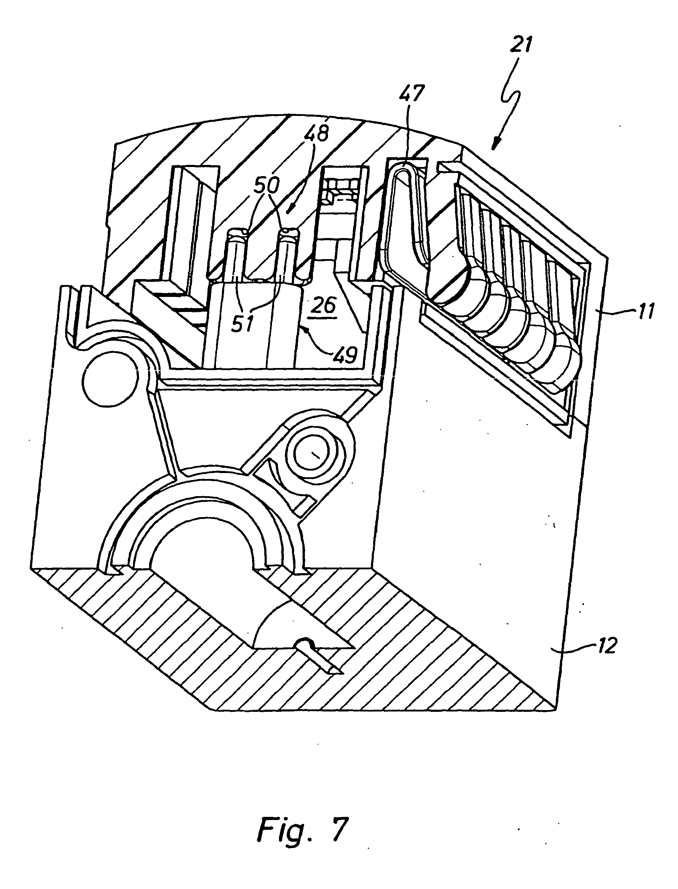

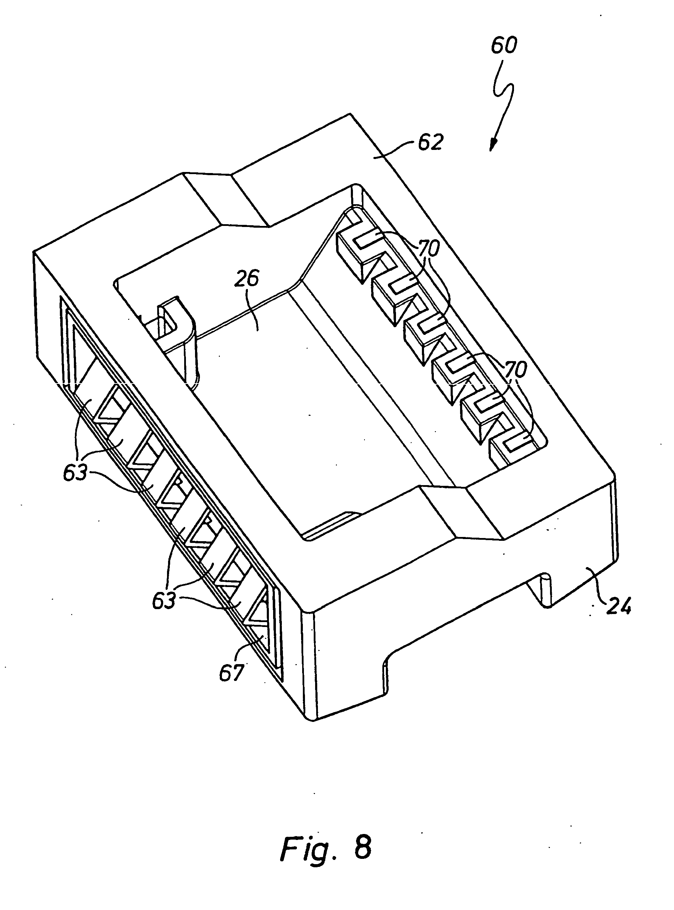

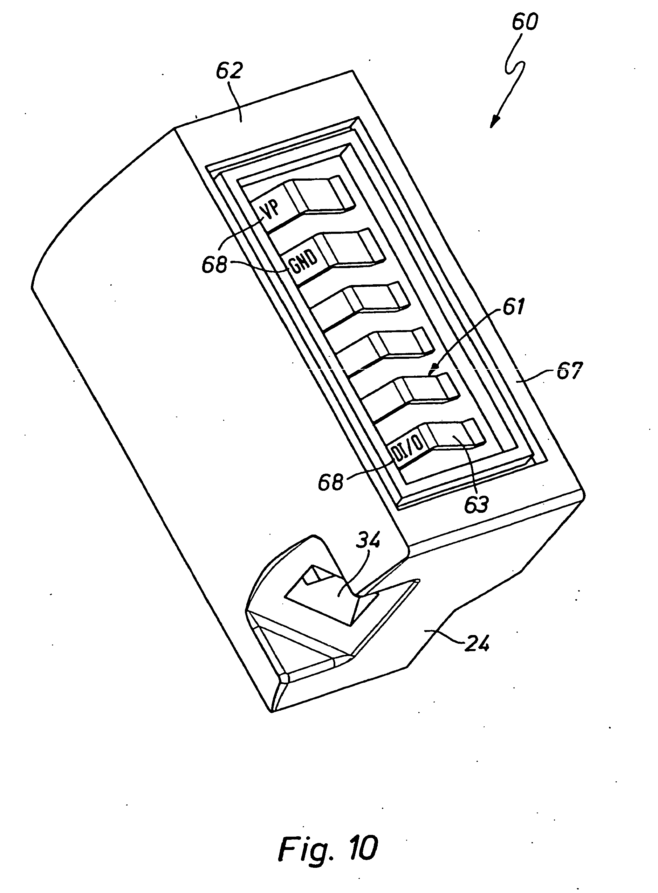

Das Gehäuse 31 des Verkettungsmoduls 11 dient als räumlicher Schaltungsträger 30, bei dem Leiterbahnen am und/oder im Gehäuse, gegebenenfalls mehrschichtig als sogenannte Multilayer-Bauform, geführt sind. Daher ist eine separate Leiterplatte, auf der elektrische Bauteile angeordnet sind, nicht unbedingt notwendig, wobei allerdings eine Variante der Erfindung, die im Zusammenhang mit Fig. 5 näher erläutert wird, zusätzlich eine solche Leiterplatte vorsieht. Bei den Leiterbahnen sind mehrere, beliebig miteinander kombinierbare Varianten möglich: Das in den Fig. 3 bis 8 gezeigte Verkettungsmodul 11 enthält auf das Gehäuse 31 aufgedampfte und/oder galvanisch angebrachte metallische Leiterbahnen, wohingegen das Verkettungsmodul 60 (Figuren 8 -10) ein integriertes metallisches Stanz-Biegeteil 61 aufweist, das zumindest teilweise Leiterbahnen eines räumlichen Schaltungsträgers bildet.

Zur Fertigung des Gehäuses 31 eignen sich vorzugsweise MID-Verfahren, wobei unterschiedliche bekannte MID-Verfahren anwendbar sind. Diese können auch in Zusammenwirken mit einem Stanz-Biegeteil, das später noch erläutert wird, verwendet werden.

Das Gehäuse 31 ist vorliegend im sogenannten 2-Schuss-Verfahren hergestellt (2K-Verfahren). Dabei wird z.B. in einem ersten Schuss ein Grundgehäuse, ein sogenannter Vorspritzling, aus einem metallisierbaren Kunststoff spritzgegossen. Dann werden die Räume zwischen den Leiterbahnen mit einem nicht-metallisierbaren Kunststoff ausgefüllt. Bei einer bevorzugten Variante der Erfindung ist dieser zweite Kunststoff laseraktivierbar. Sodann wird selektiv eine Metallschicht auf den Leiterbahn-Bereichen galvanisch abgeschieden, wofür auf dem metallisierbaren Kunststoff Palladiumkeime vorhanden sind. Als Kunststoffmaterial empfiehlt sich vorzugsweise Kunststoff mit der Bezeichnung PA66-GF, PC/ABS oder LCP (Vectra E820i-Pd). Ferner sind geeignete metallisierbare Kunststoffe z.B. auch Polyarylamid (PAA), Polyphthalamid (PPA) oder Polybutylenterphthalat (PBT). Die beiden letzteren Kunststoffe, PPA und PBT, sind insbesondere in Bezug auf das nachfolgende Verlöten der elektrischen Bauelemente vorteilhaft, wobei prinzipiell auch andere Kunststoffe zum Einsatz kommen können. Laseraktivierbare Kunststoffe sind beispielsweise PA6/6TMID, PBTMID oder PPMID, das von der Firma LPKF Laser & Electronics AG, 30827 Garbsen, Deutschland, vertrieben wird.

Besonders bevorzugt ist eine Kombination des Zweikomponenten-Spritzgießens (2K-Verfahren) mit einer anschließenden Metallisierung und/oder Strukturierung, die an sich beim Einkomponenten-Spritzgießen verwendet wird. Beispielsweise wird beim zweiten Schuss ein laseraktivierbarer Kunststoff verwendet. Auf diesem kann mittels eines Lasers das im Aufnahmeraum 26 benötigte Layout strukturiert werden. Durch den über die Oberfläche des laseraktivierbaren Kunststoffs hinweggeführten Laserstrahl erfolgt eine lokale Aktivierung von dessen Oberfläche, durch die das gewünschte Schaltungs-Layout erzeugt wird. In den bestrahlten Oberflächenbereichen findet eine lokale Materialaktivierung statt. Zum einen werden aus speziellen, nichtleitenden Wirksubstanzen Metallkeime abgespalten oder die Metallkeimumhüllung aufgebrochen. Gleichzeitig können weitere Füllstoffe des Kunststoffmaterials eine ausgeprägte Rauhigkeit auf den bestrahlten Oberflächenbereichen erzeugen. Dadurch werden auf dem von Hause aus nicht metallisierbaren zweiten Trägersubstrat entsprechend aktivierte Metallisierungsmuster erzeugt, auf denen nun bei einem sich anschließenden galvanischen Metallisierungsprozess eine Metallisierung erfolgen kann. Im Bereich der abgespaltenen und teilweise freigelegten Metallkeime findet beispielsweise eine lokale, der Laserspur folgende Kupfermetallisierung statt, wobei durch die Rauhigkeit eine sehr gute Haftung für die im Galvanikbad entstehende Metallschicht gewährleistet wird.

Ein alternatives subtraktives Verfahren sieht z.B. vor, dass das Formteil z.B. zunächst vollflächig chemo-galvanisch metallisiert und mit einem Ätz-Resist beschichtet wird. Der Laser trägt im Bereich zwischen den Leiterbahnen den Ätz-Resist ab, so dass das freigelegte Kupfer weggeätzt werden kann. Sodann wird das verbleibende Ätz-Resist entfernt und die Kupferoberfläche beispielsweise durch eine Metallisierung gegen Oxidation geschützt. Somit können sehr feine Leiterbahnstrukturen mit einem Leiterbahnabstand von beispielsweise 50 µm hergestellt werden.

Ferner kann die Leiterbahnstruktur auch im Heißprägestempel-Verfahren aufgebracht werden. Dabei wird aus einer elektrisch leitfähigen Folie mit einem heißen Metallstempel die Leiterbahnstruktur gleichzeitig ausgestanzt und auf den Schaltungsträger aufgeprägt. Auch eine Strukturierung der Leiterbahnen mittels des PVD-Verfahrens ist möglich (PVD = Physical Vapor Deposition). Hierbei werden die Leiterbahnschichten durch Sputtern oder Verdampfen im Vakuum aufgebracht, wobei nur zwei Prozessschritte, nämlich Aktivierung und Metallisierung, notwendig sind. Man erhält sehr homogene Schichten. Es besteht auch ferner die Möglichkeit, dass diese Schichten später noch galvanisch verstärkt werden.

Bei der Strukturierung der Leiterbahnen können also die bekannten Subtraktiv-, Semiadditiv- und Additivprozesse eingesetzt werden. Beim Subtraktivprozess wird zuerst eine Metallschicht über die gesamte Fläche bis zur gewünschten Schichtstärke abgeschieden und im Anschluss strukturiert. Es ist auch möglich, die Leiterstruktur bereits auf der chemisch aufgebauten Metallschicht festzulegen und diese selektiv im Rahmen eines Semiadditivprozesses bis zur gewünschten Schichtstärke zu verstärken. Beim Additivprozess liegt die Leiterbahnstruktur bereits vor der Metallisierung fest, sodann erfolgt selektiv ein Metallaufbau auf diese Struktur.

Die Vorteile des MID-Verfahrens bzw. der Verwendung eines im Gehäuse des Verkettungsmoduls 60 vergossenen Stanz-Biegeteils sind, dass Einbautoleranzen vermieden werden, die mechanische Belastung von den elektrischen Steuerungskomponenten 27 im Aufnahmeraum 26 gering ist und zudem durch eine minimierte Anzahl von elektrischen Übergangsstellen die elektrischen Übergangswiderstände gering gehalten werden.

Zur Verringerung elektrischer Übergangswiderstände tragen auch weitere bei dem Verkettungsmodul 11 verwirklichte Maßnahmen bei:

An gegenüberliegenden Seiten des Verkettungsmoduls 11 sind jeweils Verkettungskontakte 37 angeordnet. Die Verkettungskontakte 37 liegen bei in der Ventilbatterie 14 montiertem Verkettungsmodul 11 flächig an Verkettungskontakten 37 eines benachbarten Verkettungsmoduls 11 bzw. an Verkettungskontakten des Abschlussmoduls 15 an. Die Verkettungskontakte 37 sind vorzugsweise pin-gleich durchgeschleift und bilden den Bus 32. Bei diesem kann es sich um z.B. einen parallelen und/oder seriellen Bus handeln, beispielsweise einen Feldbus. Jeweils ein Paar von an gegenüberliegenden Seiten des Verkettungsmoduls 11 angeordneten Verkettungskontakten 37 ist einer Busleitung des Busses 32 zugeordnet. Zur Verringerung des elektrischen Übergangswiderstandes verläuft eine durchgehende Leiterbahn zwischen jeweils zwei an gegenüberliegenden Seiten des Verkettungsmoduls 11 angeordneten Verkettungskontakten 37. Exemplarisch ist dies an den Leiterbahnen 38, 39 erkennbar. Diese führen von Verkettungskontakten 40, 40', die an einer Seitenwand 42 des Verkettungsmoduls 11 angeordnet sind, zu Verkettungskontakten 41, 41', die an der gegenüberliegenden Seitenwand 43 des Verkettungsmoduls 11 angeordnet sind. Zudem bilden die Leiterbahnen 38, 39 die Kontaktflächen der Verkettungskontakte 40, 40', 41, 41'. Somit ist innerhalb des Verkettungsmoduls 11 keinerlei elektrische Stoßstelle zwischen den Verkettungskontakten 41, 41' und 40, 40' vorhanden.

Zu einer weiteren Verminderung elektrischer Übergangswiderstände trägt bei, dass an beiderseits des Verkettungsmoduls 11 angeordnete Verkettungskontakte verknüpfende Leiterbahnen, beispielsweise an den Leiterbahnen 38, 39, unmittelbar die Steuerungskomponenten 27 angeordnet sind. Beispielsweise sind auf die Leiterbahnen 38, 39 ein elektrischer Kondensator sowie der Chip 28 gelötet.

Bei montierter Ventilbatterie 14 sind die Verkettungskontakte 37 nach außen hin verdeckt (siehe Fig. 2). An jeder Seitenwand 42, 43 sind die jeweiligen Verkettungskontakte 37 zu Kontaktbereichen 44, 45 gruppiert. Die Kontaktbereiche 44, 45 können von einer umlaufenden Kunststoff- oder Gummidichtung umgeben sein. Möglich ist es auch, lediglich eine U-förmige Dichtung vorzusehen, die beispielsweise oben und seitlich die Kontaktbereiche 44 bzw. 45 vor Umwelteinflüssen schützt. Ferner können bei den Verkettungskontakten 37 im montierten Zustand benachbarter Verkettungsmodule 11 ineinander greifende Vorsprünge und Ausnehmungen vorgesehen sein.

Die Ausführungsbeispiele zeigen verschiedene Arten von Verkettungskontakten 37. Beim Verkettungsmodul 11 sind die Kontakte des Kontaktbereiches 44, z.B. die Verkettungskontakte 40, 40', als nicht-federnde elektrische Auflageflächen ausgestaltet. Gegenüber der Außenkontur des Gehäuses 31 sind diese Kontaktflächen geringfügig zurückversetzt, so dass sie geschützt sind.

An der gegenüberliegenden Seitenwand 43 befinden sich metallisierte Kunststoffglieder 46, die im montierten Zustand des Verkettungsmoduls 11 in elektrischem Kontakt zu nicht-federnden elektrischen Auflageflächen eines benachbarten Verkettungsmoduls 11 oder des Abschlussmoduls 15 stehen.

Prinzipiell wäre es zwar möglich, die Kunststoffglieder 46 federnd auszugestalten, wobei sie ohne ein zusätzliches Federglied unter Federspannung stünden und für Kontaktsicherheit sorgten. Beim Ausführungsbeispiel jedoch ist eine mit einem elektrisch nicht-leitenden Überzug versehene Federanordnung 47 vorgesehen, die die Kunststoffglieder 46 in Richtung eines benachbarten Verkettungsmoduls vorspannt. Die Federanordnung 47 ist vorliegend eine einstückige Feder in Form eines Stanz-Biegeteils, das zwischen die Kontakt-Kunststoffglieder 46 und die Seitenwand 43 gespannt ist. Die Federanordnung 47 ist vorliegend ein gefalzter Metallstreifen mit einem V-förmigen oder U-förmigen Querschnitt. Durch den nicht-leitenden Überzug wird eine elektrische Verbindung zwischen den einzelnen metallisierten Kunststoffgliedern 46 vermieden. Prinzipiell wäre es zur elektrisch Isolation aber auch möglich, dass die Kunststoffglieder 46 auf der der Federanordnung 47 zugewandten Seite nicht mit einem elektrisch leitenden Metallüberzug versehen sind.

Der nicht-leitende Überzug der Federanordnung 47 besteht beispielsweise aus einer Pulverbeschichtung und/oder einer Kunststofffolie. Die Federanordnung 47 liefert die für eine zuverlässige Kontaktherstellung notwendige Kontaktkraft, so dass auch bei einer eventuellen Ermüdung des Kunststoffes der Glieder 46 die notwendige Kontaktsicherheit gewährleistet ist. Die Seitenwand 43 dient der Federanordnung 47 als Anschlag. Die Kunststoffglieder 46 sind beweglich am Gehäuse 31 gelagert und vorliegend mit diesem einstückig.

Bei einer kammartigen, nicht dargestellten Variante der Federanordnung, bei der z.B. jeweils eine Zinke einem metallisierten Kunststoffglied 46 zugeordnet wäre, oder wenn jedem Kunststoffglied 46 jeweils ein separates Federglied zugeordnet wäre, würde die Kontaktkraft individuell für jedes einzelne Kunststoffglied 46 bereitgestellt werden, was eventuelle Fertigungstoleranzen zwischen den einzelnen Kunststoffgliedern 46 des Kontaktbereiches 45 und/oder den am benachbarten Verkettungsmodul angeordneten Kontakten eines Kontaktbereiches 44 ausgleicht. Derartige Toleranzen können beispielsweise auch durch eine ungünstige Platzierung des Verkettungsmoduls 11 innerhalb der Batterie 14 hervorgerufen werden.

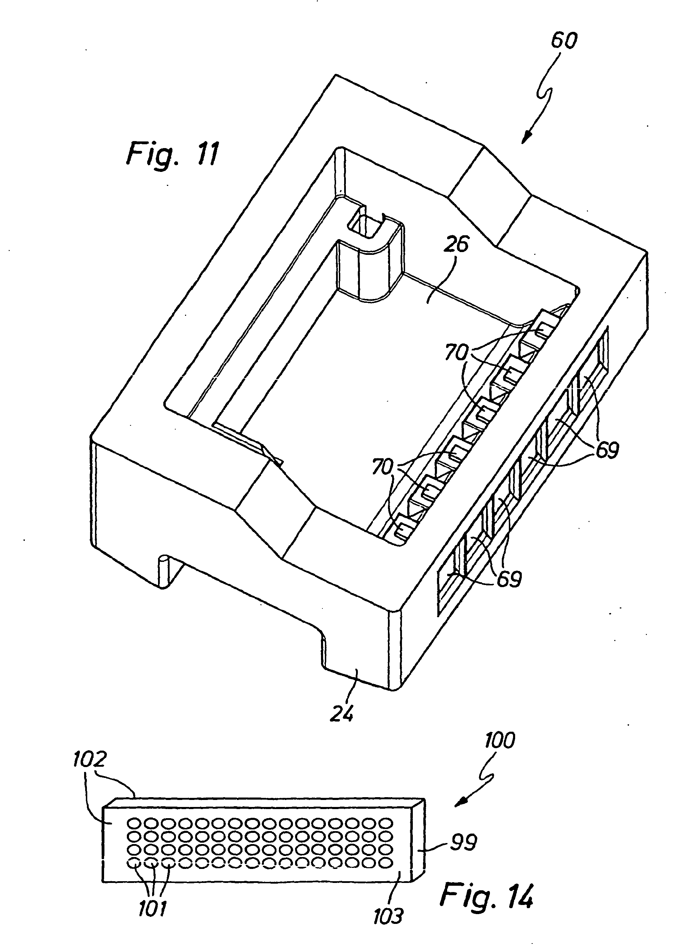

Die Verkettungskontakte 37 können auch als Metallfederkontakte und/oder durch Fuzz-Kontakte realisiert sein, was später noch im Zusammenhang mit den Fig. 8 bis 11 bzw. 12 und 13 erläutert wird.

Die Verbindung zwischen dem Verkettungsmodul 11 und dem Ventilantrieb 12 ist in einer an sich schon eine eigenständige Erfindung darstellenden Weise realisiert. Bei der Fertigung des Gehäuses 31 sowie entsprechend bei der Fertigung des Ventilantriebs 12 sind Montagetoleranzen unvermeidlich. Diese könnten bei zusammenmontierten Baugruppen 11 und 12 zu Spannungen führen, die im Extremfall zur Beschädigung der Baueinheit 21 aus Ventilantrieb 12 und Verkettungsmodul 11 führen können.

Das Verkettungsmodul 11 und der Ventilantrieb 12 weisen miteinander kooperierende elektrische Verbindungsmittel 48, 49 auf, über die das Verkettungsmodul 11 den Ventilantrieb 12 steuern und überwachen kann. Im vorliegenden Fall handelt es sich um Steckverbindungsmittel, wobei auf Seiten des Verkettungsmoduls 11 Buchsen oder Steckaufnahmen 50 und beim Ventilantrieb 12 Steckkontakte 51 vorgesehen sind. Beispielsweise sind in dem Ventilantrieb 12 Spulen (nicht sichtbar) vorgesehen, die vom Gehäuse des Ventilantriebs 12 umgeben sind, beispielsweise im Rahmen eines Spritzgussverfahrens umspritzt sind, und deren Drahtenden mit den Steckkontakten 51 versehen sind. Die Steckkontakte 51 weisen einen geringeren Durchmesser auf als die Steckaufnahmen 50. Dementsprechend haben sie in diesen Steckaufnahmen Spiel, können also spannungsfrei in die Steckaufnahmen 50 eingeführt werden. Der Zwischenraum zwischen den Steckkontakten 51 und den Steckaufnahmen 50 wird mit einem Kontaktwerkstoff, beispielsweise Leitklebstoff, verfüllt, der bei der Montage noch flüssig ist, dann jedoch aushärtet und eine stabile und elektrisch dauerhaft sichere Verbindung zwischen den Verbindungsmitteln 48, 49 herstellt. Die Aushärtung findet z.B. statt, nachdem das Verkettungsmodul 11 mit dem Ventilantrieb 12 verklebt und/oder verschweißt worden ist. Die Steckaufnahmen 50 sind beispielsweise am Gehäuse 31 angeordnete Ausnehmungen, die mit einem Metallüberzug versehen sind, der z.B. im Rahmen des MID-Verfahrens aufgebracht wird. Auch diese Maßnahme trägt zur Verringerung elektrischer Übergangswiderstände bei.

Von den äußeren Kontaktflächen der Verkettungskontakte 37 führen Verbindungsleitungen, die vorliegend durch homogene Leiterbahnen gebildet werden, ins Innere, das heißt in den Aufnahmeraum 26 des Verkettungsmoduls 11. Hierfür sind beispielsweise Durchkontaktierungen 96 vorgesehen.

Bei der in Figur 5 gezeigten Variante 11' des Verkettungsmoduls 11 ist eine optionale elektrische Zusatz-Komponente in Form einer Leiterplatte 52 vorgesehen. Die Grundfunktionen des Verkettungsmoduls 11' werden im Wesentlichen durch den Chip 28 realisiert. Wenn im Anwendungsfall zusätzliche Funktionalität erforderlich ist, beispielsweise zusätzliche Diagnosefunktionen, kann die Leiterplatte 52 im Verkettungsmodul 11' montiert werden. Somit ist es ohne weiteres möglich, das Verkettungsmodul 11' individuell an unterschiedliche Rahmenbedingungen, beispielsweise an unterschiedlich ausgestaltete Ventilantriebe, anzupassen. Beispielsweise könnte es beim Ventilantrieb 12 Varianten mit unterschiedlichen Anzahlen von Antriebsspulen geben. Ferner könnte die Leiterplatte 52 eine Art Verstärkerschaltung enthalten, die zur Ansteuerung entsprechend leistungshungriger Antriebsbaugruppen notwendig ist. Zudem erhöht die Leiterplatte 52 die Packungsdichte des Verkettungsmoduls 11'.

Die Leiterplatte 52 liegt auf einer Tragstruktur 53 auf, die im Aufnahmeraum 26 angeordnet ist. Die Tragstruktur 53 wird vorliegend im Wesentlichen durch die Seitenwand 43 gebildet, an deren Oberseite Kontaktflächen 54, sogenannte Pads, zur Herstellung eines elektrischen Kontaktes mit der Leiterplatte 52 angeordnet sind. Die Kontaktflächen 54 werden vorliegend durch die Leiterbahnen 38, 39 gebildet oder sind mit diesen elektrisch verbunden, so dass die elektrischen Übergangswiderstände verhältnismäßig gering sind. In der Fig. 5 ist die Leiterplatte 52 zur Veranschaulichung darunter liegender Komponenten geschnitten dargestellt. Es versteht sich, dass prinzipiell auch mehrere Leiterplatten im Aufnahmeraum 26 anordenbar sind. Diese Leiterplatten könnten beispielsweise auch senkrecht im Aufnahmeraum 26 stehen.

Auch das Verkettungsmodul 11 gemäß Figur 4 kann Kontaktflächen 54' aufweisen, die jedoch im Vergleich zu den Kontaktflächen 54 des Verkettungsmoduls 11' nach unten zurückversetzt sind. Zur Herstellung elektrischer Verbindungen mit diesen Kontaktflächen 54' können an einer entsprechend ausgestalteten Leiterplatte beispielsweise vorstehende Kontakte vorgesehen sein.

Bei dem Verkettungsmodul 60 gemäß Fig. 8 bis 11 sind zum einen wie beim Verkettungsmodul 11 nicht-federnde Kontaktflächen als Verkettungskontakte 37 vorgesehen, zum andern jedoch anstelle der federnden, metallisierten Kunststoffglieder 46 Metallfederkontakte 63, die durch ein Stanz-Biegeteil 61 gebildet werden. Das Stanz-Biegeteil 61 ist mit einem elektrisch isolierenden Kunststoff umspritzt. Es bildet einen integralen Bestandteil des Gehäuses 62 des Verkettungsmoduls 60. Das Verkettungsmodul 60 entspricht ansonsten im Wesentlichen dem Verkettungsmodul 11. Im Folgenden sind gleiche oder funktional gleiche Komponenten mit denselben Bezugszeichen versehen. Zudem sind im Aufnahmeraum 26 angeordnete elektrische Steuerungskomponenten 27 aus Gründen der Einfachheit nicht dargestellt.

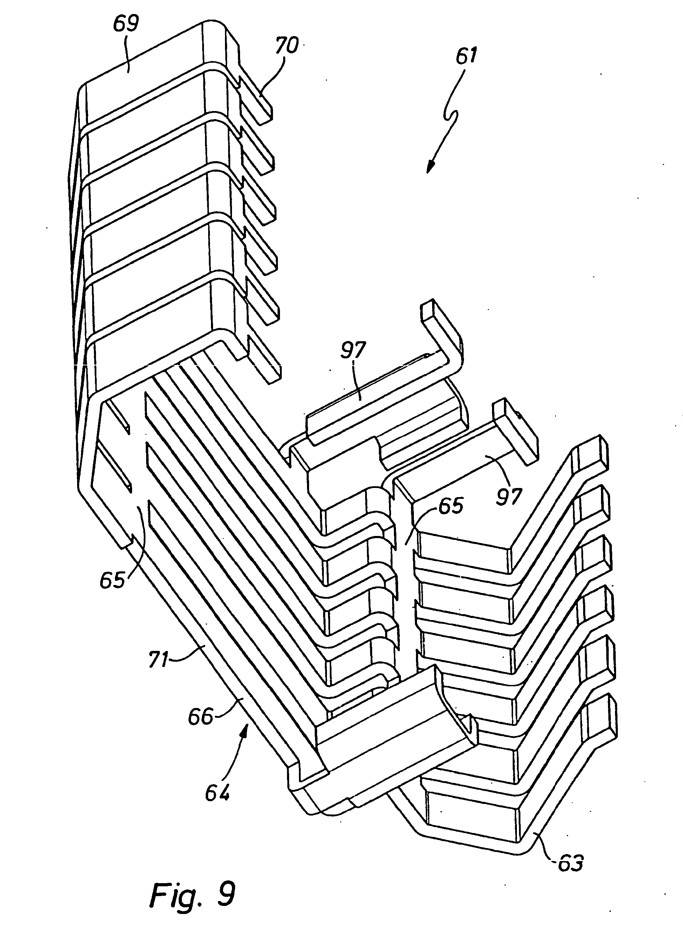

Fig. 9 zeigt das Stanz-Biegeteil 61 in noch unvergossenem Zustand, wobei es jedoch schon im Wesentlichen die auch nach dem Vergießen vorhandene äußere Gestalt aufweist. Das Stanz-Biegeteil 61 hat eine Art Gitterstruktur mit einer Längsstruktur 64 mit Lamellen 66, die durch eine Querstruktur 65 zusammengehalten werden. Nach dem Umspritzen des Stanz-Biegeteils 61 wird die Querstruktur 65 entfernt, so dass die einzelnen Lamellen 66 der Längsstruktur 64 elektrisch voneinander isoliert sind. Die Lamellen 66 werden dann vom Gehäuse 62 gehalten. Prinzipiell wäre es auch möglich, dass bereits individualisierte Lamellen mit dem Kunststoff des Gehäuses 62 umspritzt werden.

Jede Lamelle 66 weist einen im Wesentlichen U-förmigen Querschnitt auf. An jedem Schenkel sind dabei Verkettungskontakte 37 angeordnet, nämlich Federkontakte 63 und Kontaktflächen 69. Für die Federkontakte 63 bildet eine Seitenwand 67 des Gehäuses 62 einen Anschlag. Die Federkontakte 63 sind in Richtung von dem Gehäuse 62 weg vorgespannt und weisen eine von diesem wegweisende V-förmige Krümmung auf. Außen an jedem Metallfederkontakt 63 ist optional eine Beschriftung 68 angebracht, z.B. VP, GND oder DI/O, die die am jeweiligen Metallfederkontakt 63 anliegende Versorgungsspannung (GND = Ground) oder sonstiges Bussignal, z.B. DI/O = Digital Input/Output, bezeichnet. An der den Metallfederkontakten 63 gegenüberliegenden Seite bilden die Lamellen 66 Kontaktflächen 69, die im montierten Zustand nicht federn und einen Anschlag für Federkontakte eines zum Verkettungsmodul 60 benachbart angeordneten Verkettungsmoduls bilden.

Nahe bei den Kontaktflächen 69 sind die freien Enden der Lamellen 66. Sie sind nach innen gebogen und bilden Kontaktflächen 70, auf denen ähnlich wie auf den Kontaktflächen 54 des Verkettungsmoduls 11 eine Leiterplatte oder eine sonstige elektrische Komponente montiert werden kann. Von den beiden äußeren seitlichen Lamellen 66 stehen Trägerelemente 97 ab, an denen oberseitig Kontaktflächen 98 ausgebildet sind. Die Kontaktflächen 98 stehen mit den äußeren seitlichen Lamellen 66 elektrisch in Verbindung und dienen wie die Kontaktflächen 70 als elektrische Kontaktmittel und vorliegend zugleich als Trägerstruktur für eine nicht dargestellte elektrische Komponente, z.B. eine Leiterplatte.

An mittleren Abschnitten 71 der Lamellen 66 zwischen den Metallfederkontakten 63 und den Kontaktflächen 69 liegen im montierten Zustand des Gehäuses 62 zumindest teilweise frei. An ihnen können unmittelbar elektrische Komponenten in der Art der Steuerungskomponenten 27 angeordnet werden. Hierdurch werden die elektrischen Übergangswiderstände minimiert. Die mittleren Abschnitte 71 bilden sozusagen Leiterbahnen.

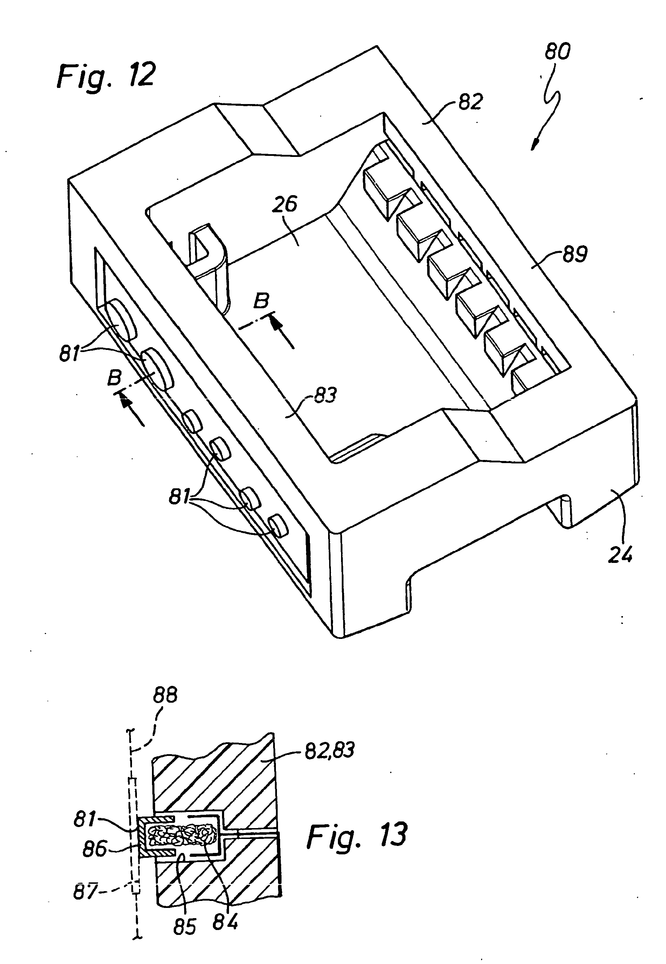

Bei einem Verkettungsmodul 80 gemäß Fig. 12 und 13 sind anstelle der metallisierten, federnden Kunststoffglieder 46 kompressible, federnde Metallstruktur-Kontakte, sogenannte Fuzz-Kontakte, vorgesehen. Ansonsten entspricht das Verkettungsmodul 80 im Wesentlichen dem Verkettungsmodul 11, wobei in der Zeichnung aus Gründen der Veranschaulichung einige Komponenten nicht dargestellt sind.

Das Gehäuse 82 ist im Wesentlichen in MID-Technologie hergestellt. Die Fuzz-Kontakte 81 sind an einer Seitenwand 83 des Gehäuses 82 angeordnet. Sie werden im Wesentlichen durch eine kompressible, federnde Metallstruktur 84, die beispielsweise zu einer Art Zylinder vorgeformt ist, gebildet. Die Metallstruktur 84 besteht beispielsweise aus Berylliumkupferdraht mit einem Überzug aus Gold, der zu einem Knäuel geformt ist. Die Metallstruktur 84 sitzt in einer Aufnahme 85 in der seitenwand 83. Die Aufnahme 85 ist innenseitig mit einem elektrisch leitenden Überzug, beispielsweise aus Metall, versehen. Vorzugsweise führen die Leiterbahnen 29 in die Aufnahmen 85 hinein, wodurch der elektrische Übergangswiderstand verringert wird. Der metallische Überzug der Aufnahme 85 wird beispielsweise im Rahmen einer MID-Beschichtung aufgebracht.

Auf der Metallstruktur 84 sitzt ein fester Hut 86 aus elektrisch leitendem Material, beispielsweise Kupferblech, dessen Stirnseite den Kontakt zu einer Kontaktfläche 87 eines benachbart zum Verkettungsmodul 80 angeordneten Verkettungsmoduls 88 herstellt. Dabei wird die Metallstruktur 84 komprimiert, das heißt, sie tritt weiter in die Aufnahme 85 ein, wobei der federnde Charakter der Metallstruktur 84 zuverlässig die elektrische Verbindung zur Kontaktfläche 87 herstellt.

An der der Seitenwand 83 gegenüberliegenden Seitenwand 89 sind nicht-federnde, feststehende Kontaktflächen 87 in der Art der Kontaktflächen 40 bzw. 69 angeordnet. Diese Kontaktflächen treten ebenfalls gegenüber der Seitenwand 89 geringfügig zurück.

Es versteht sich, dass auch Fuzz-Kontakte ohne festen Hut 86 prinzipiell möglich sind.

Eine Variante zu einer Verbindung von Verkettungskontakten, insbesondere in Gestalt nicht-federnder Kontaktflächen, ist in Fig. 14 teilweise schematisiert dargestellt. In einem elastischen Isolator 99, z.B. Silikon, eines verbindungselements 100 sind Leiter 101, z.B. feine Metalldrähte, angeordnet. In der Figur haben die Leiter aus Veranschaulichungsgründen einen großen Durchmesser. Die Leiter 101 durchdringen den Isolator 99 und verlaufen zwischen den jeweiligen Stirnseiten 102 des Verbindungselements 100 und münden an den Stirnseiten 102. Die Leiter 101 sind in den Isolator 99 eingebettet und durch diesen gegeneinander elektrisch isoliert.

Die Leiter 101 liegen im montierten Zustand beispielsweise auf nicht-federnden Kontaktflächen 69 oder 87 benachbarter Verkettungsmodule 60 oder 88 auf (wenn diese beispielsweise anstelle der Metallfederkontakte 63 bzw. der Fuzz-Kontakte 81 auf beiden Seiten nur nicht-federnde Kontaktflächen 69 bzw. 87 hätten) und verbinden die benachbarten, gegenüberliegenden Kontaktflächen 69, 87 benachbarter Verkettungsmodule 60, 88.

Bei der Montage der Verkettungsmodule 60, 88 kommt das Verbindungselement 100 zwischen den Verkettungsmodulen 60, 88 zu liegen und wird um ein vorbestimmtes Maß komprimiert, so dass es fest zwischen den Verkettungsmodulen 60, 88 sitzt und die Leiter 101 elektrisch zuverlässig mit den Kontaktflächen 69, 87 in Kontakt sind. Durch ausreichend große seitliche Abstände zwischen den Kontaktflächen 69, 87 eines Verkettuügsmoduls 60, 88 wird ein elektrischer Kurzschluss zwischen diesen Kontaktflächen 69, 87 durch das Verbindungselement 100 verhindert. Ein um die Leiter 101 rahmenartig angeordneter Randbereich 103 isoliert die Kontaktflächen 87 gegenüber Umwelteinflüssen. Zur Aufnahme des Verbindungselements 100 kann im Bereich der Kontaktflächen 87 eine Vertiefung vorgesehen sein.

## Patentansprüche

1. Verkettungsmodul, das mit weiteren Verkettungsmodulen batterieartig verkettbar ist, mit einem Gehäuse (31) und mit seitlichen Verkettungskontakten (37) an dem Gehäuse (31) zur elektrischen Kontaktierung mindestens eines weiteren Verkettungsmoduls (11; 60; 80), **dadurch gekennzeichnet, dass** das Gehäuse (31) als spritzgegossener, räumlicher Schaltungsträger (30) in der Bauart eines Moulded Interconnect Devices (MID) ausgestaltet ist und Leiterbahnen (29; 38; 39) enthält, an denen mindestens eine an dem Schaltungsträger (30) elektrische Komponente (28) für eine Steuerungsfunktion und/oder Überwachungsfunktion und/oder eine Kommunikationsfunktion angeordnet ist.

2. Verkettungsmodul nach Anspruch 1, **dadurch gekennzeichnet, dass** die Verkettungskontakte (37) im batterieartig montierten Zustand der Verkettungsmodule flächig aneinander anliegen.

3. Verkettungsmodul nach Anspruch 1 oder 2, **dadurch gekennzeichnet, dass** die Verkettungskontakte (37) durch das Gehäuse (31) gebildet werden und/oder einen integralen Bestandteil des Gehäuses (31) bilden.

4. Verkettungsmodul nach einem der vorhergehenden Ansprüche, **dadurch gekennzeichnet, dass** es aufgedampfte oder galvanisch aufgebrachte oder durch Heißprägen aufgebrachte metallische Leiterbahnen (29) oder durch mindestens ein integriertes metallisches Stanz-Biegeteil (61) gebildete Leiterbahnen (29) aufweist.

5. Verkettungsmodul nach einem der vorhergehenden Ansprüche, **dadurch gekennzeichnet, dass** die Verkettungskontakte (37) im batterieartig montierten Zustand nach außen hin verdeckt sind.

6. Verkettungsmodul nach einem der vorhergehenden Ansprüche, **dadurch gekennzeichnet, dass** die Verkettungskontakte (37) an gegenüberliegenden Seiten (42, 43) des Verkettungsmoduls (11; 60; 80) angeordnet und insbesondere über durchgehende Leiterbahnen (38, 39) miteinander verbunden sind.

7. Verkettungsmodul nach Anspruch 6, **dadurch gekennzeichnet, dass** die durchgehenden Leiterbahnen (38, 39) Kontaktflächen der Verkettungskontakte (37) bildet.

8. Verkettungsmodul nach einem der vorhergehenden Ansprüche, **dadurch gekennzeichnet, dass** mit einer zu steuernden und/oder überwachenden Modul-Einheit (90) verbindbar ist, wobei das Verkettungsmodul und die Modul-Einheit (90) insgesamt ein Batteriemodul (10) bilden, das mit weiteren Batteriemodulen (10) zu der einer Modul-Batterie (14) koppelbar ist.

9. Verkettungsmodul nach Anspruch 8, **dadurch gekennzeichnet, dass** die mindestens eine elektrische Komponente (28) zur Steuerung und/oder Überwachung der Modul-Einheit (90) ausgestaltet ist.

10. Verkettungsmodul nach Anspruch 8 oder 9, **dadurch gekennzeichnet, dass** die mindestens eine elektrische Komponente (28) für eine Kommunikation der Modul-Einheit (90) und/oder des Verkettungsmoduls mit weiteren Batteriemodulen (10) oder einer Steuerung der Batterie ausgestaltet ist.

11. Verkettungsmodul nach Anspruch 9 oder 10, **dadurch gekennzeichnet, dass** die mindestens eine elektrische Komponente (28) an mindestens einer durchgehenden, zwei an gegenüberliegenden Seiten (42, 43) des Verkettungsmoduls (11; 60; 80) angeordnete Verkettungskontakte (37) verbindenden Leiterbahn (38, 39) angeordnet und mit dieser elektrisch verbunden ist.

12. Verkettungsmodul nach Anspruch 9, 10 oder 11, **dadurch gekennzeichnet, dass** es einen im montierten Zustand verschlossenen Aufnahmeraum (26) für die mindestens eine elektrische Komponente (28) aufweist.

13. Verkettungsmodul nach einem der Ansprüche 8 bis 12, **dadurch gekennzeichnet, dass** es Verbindungsmittel (48), insbesondere Steckverbindungsmittel (50), zur elektrischen Verbindung mit der Modul-Einheit (90) aufweist.

14. Verkettungsmodul nach Anspruch 13, **dadurch gekennzeichnet, dass** die Verbindungsmittel (48) des Verkettungsmoduls (11; 60; 80) mit kooperierenden Verbindungsmitteln (49) der Modul-Einheit (90) im montierten Zustand mit einem Leitklebstoff verbunden sind, der insbesondere einen zwischen den jeweiligen Verbindungsmitteln (48, 49) ansonsten vorhandenen Zwischenraum ausfüllt.

15. Verkettungsmodul nach einem der Ansprüche 8 bis 14 **dadurch gekennzeichnet, dass** es mit der Modul-Einheit (90) stoffschlüssig verbunden, insbesondere verschweißt und/oder verklebt, ist.

16. Verkettungsmodul nach einem der vorhergehenden Ansprüche, **dadurch gekennzeichnet, dass** an jeweils einer Seite (42, 43) des Verkettungsmoduls (11; 60; 80) angeordneten Verkettungskontakte (37) zu einem insbesondere durch ein nach außen abdichtendes Dichtungsmittel versehenen Kontaktbereich (44; 45) gruppiert sind.

17. Verkettungsmodul nach einem der vorhergehenden Ansprüche, **dadurch gekennzeichnet, dass** die Verkettungskontakte (37) durch metallisierte Kunststoffglieder (46) oder durch Metallfederkontakte (63) oder durch Fuzz-Kontakte (81) gebildet werden.

18. Verkettungsmodul nach einem der vorhergehenden Ansprüche, **dadurch gekennzeichnet, dass** zur elektrischen Verbindung der Verkettungskontakte (37) benachbarter Verkettungsmodule gegeneinander elektrisch isolierte, in einem elastischen Isolator angeordnete Leiter vorgesehen sind, wobei im montierten Zustand der elektrische Isolator zwischen den benachbarten Verkettungsmodulen zu liegen kommt und die elektrischen Leiter die Verkettungskontakte der Verarbeitungsmodule miteinander verbinden.

19. Verkettungsmodul nach einem der vorhergehenden Ansprüche, **dadurch gekennzeichnet, dass** die Verkettungskontakte (37) metallisierte Kunststoffglieder (46) enthalten, die durch eine metallische, insbesondere mit einem elektrisch nichtleitenden Überzug versehenen Federanordnung (47) mit mindestens einer Feder und/oder einen metallischen Federkamm vorgespannt sind.

20. Verkettungsmodul nach einem der vorhergehenden Ansprüche, **dadurch gekennzeichnet, dass** die Verkettungskontakte (37) im Wesentlichen durch eine im Zweikomponenten-Spritzgießverfahren hergestellte Trägerstruktur gebildet werden, und dass im Innern des Verkettungsmoduls (11; 60; 80) eine Leiterbahnstruktur (29) auf laseraktiviertem Material ausgebildet ist.

21. Verkettungsmodul nach einem der vorhergehenden Ansprüche, **dadurch gekennzeichnet, dass** es Leuchtmittel (33) zur Anzeige mindestens einer Funktion des Verkettungsmoduls (11; 60; 80) aufweist.

22. Verkettungsmodul nach einem der vorhergehenden Ansprüche, **dadurch gekennzeichnet, dass** es mit einer fluidtechnischen Ventilanordnung (13) koppelbar oder fest verbunden ist und eine Ventilbaugruppe (10) bildet, die mit einer oder mehreren weiteren derartigen Ventilbaugruppen (10) zu einer Ventilbatterie (14) zusammenkoppelbar ist, und dass es einen elektrischen Ventilantrieb (12) zur Betätigung der fluidtechnischen Ventilanordnung und/oder Verbindungsmittel (48) zu einer elektrischen Verbindung und Ansteuerung eines elektrischen Ventilantriebs (12) zur Betätigung der fluidtechnischen Ventilanordnung enthält.

23. Modul-Einheit (90), insbesondere Ventilbaugruppe, oder Batterie, insbesondere Ventilbatterie (14), mit mindestens einem Verkettungsmodul (11; 60; 80) nach einem der vorhergehenden Ansprüche.

## Claims

1. Interlinking module capable of connection to further interlinking modules in a banked manner, with a housing (31) and with lateral interlinking contacts (37) on the housing (31) for establishing an electric contact with at least one further interlinking module (11; 60; 80), **characterised in that** the housing (31) is designed as an injection moulded, three-dimensional circuit carrier (30) of the type of a moulded interconnect device (MID) and supports conductors (29; 38; 39), at least one electrical component (28) for a control function and/or a monitoring function and/or a communication function being located on the circuit carrier (30).

2. Interlinking module according to claim 1, **characterised in that** the interlinking contacts (37) are in surface contact with one another when the interlinking modules have been assembled to form a bank.

3. Interlinking modules according to claim 1 or 2, **characterised in that** the interlinking contacts (37) are represented by the housing (31) and/or form an integral part of the housing (31).

4. Interlinking module according to any of the preceding claims, **characterised in that** it features vapour-deposited or electro-deposited or hot-stamped metallic conductors (29) or conductors (29) represented by at least one integrated metallic component produced by stamping and bending.

5. Interlinking module according to any of the preceding claims, **characterised in that** the interlinking contacts (37) are hidden from the outside when they have been assembled to form a bank.

6. Interlinking module according to any of the preceding claims, **characterised in that** the interlinking contacts (37) are located on opposite sides (42, 43) of the interlinking module (11; 60; 80) and are in particular connected to one another by continuous conductors (38, 39).

7. Interlinking module according to claim 6, **characterised in that** the continuous conductors (38, 39) form contact surfaces of the interlinking contacts (37).

8. Interlinking module according to any of the preceding claims, **characterised in that** it is connectable to a module unit (90) to be controlled and/or monitored, the interlinking module and the module unit (90) together forming a bank module (10) which can be coupled to further bank modules (10) to form a module bank (14).

9. Interlinking module according to claim 8, **characterised in that** the at least one electric component (28) is designed for the control and/or monitoring of the module unit (90).

10. Interlinking module according to claim 8 or 9, **characterised in that** the at least one electric component (28) is designed for the communication of the module unit (90) and/or the interlinking module with further bank modules (10) or for the control of the bank.

11. Interlinking module according to claim 9 or 10, **characterised in that** the at least one electric component (28) is located on and electrically connected to a continuous conductor (38, 39) connecting two interlinking contacts (37) located on opposite sides of the interlinking module (11; 60; 80).

12. Interlinking module according to claim 9, 10 or 11, **characterised in that** is incorporates a location (26) for the at least one electric component (28), which is enclosed in the assembled state.

13. Interlinking module according to any of claims 8 to 12, **characterised in that** it incorporates connecting means (48), in particular plug-and-socket means (50), for electric connection to the module unit (90).

14. Interlinking module according to claim 13, **characterised in that** the connecting means (48) of the interlinking module (11; 60; 80) are, in the assembled state, connected to co-operating connecting means (49) of the module unit (90) by means of a conductive adhesive which in particular fills the gap which would otherwise exist between the connecting means (48, 49).

15. Interlinking module according to any of claims 6 to 14, **characterised in that** it is joined to the module unit (90) by adhesive force, in particular by welding and/or bonding.

16. Interlinking module according to any of the preceding claims, **characterised in that** the interlinking contacts (37) located on one side (42, 43) of the interlinking module (11; 60; 80) are grouped to form a contact area (44; 45) provided with a sealant which seals against the outside in particular.

17. Interlinking module according to any of the preceding claims, **characterised in that** the interlinking contacts (37) are represented by metallised plastic elements (46) or by metal spring contacts (63) or by fuzz contacts (81).

18. Interlinking module according to any of the preceding claims, **characterised in that** conductors electrically insulated from one another and located in a flexible insulator are provided for the electric connection of the interlinking contacts (37) of adjacent interlinking modules, the insulator coming to lie between the adjacent interlinking modules in the assembled state and the conductors connecting the interlinking contacts of the interlinking modules to one another.

19. Interlinking module according to any of the preceding claims, **characterised in that** the interlinking contacts (37) contain metallised plastic elements (46) preloaded by a metallic spring arrangement (47) which is in particular provided with a nonconductive coating and comprises at least one spring and/or a metallic spring strip.

20. Interlinking module according to any of the preceding claims, **characterised in that** the interlinking contacts (37) are essentially represented by a carrier structure produced in a two-component injection moulding process, and **in that** a conductor structure (29) is formed in the interior of the interlinking module (11; 60; 80) on a laser-activated material.

21. Interlinking module according to any of the preceding claims, **characterised in that** it features light-emitting means (33) for the display of at least one function of the interlinking module (11; 60; 80).

22. Interlinking module according to any of the preceding claims, **characterised in that** it can be coupled or is permanently connected to a fluid power valve arrangement (13) to form a valve assembly (10), which can be coupled to one or more further similar valve assemblies (10) to form a valve bank (14), and **in that** it comprises a valve drive (12) for the actuation of the fluid power valve arrangement and/or connecting means for an electric connection and for the control of an electric valve drive (12) for the actuation of the fluid power valve arrangement.

23. Module unit (90), in particular valve assembly or valve bank (14), with at least one interlinking module (11; 60; 80) according to any of the preceding claims.

## Revendications

1. Module d'interconnexion, qui peut être connecté à la manière d'une batterie à d'autres modules d'interconnexion, comportant un boîtier (31) et des contacts d'interconnexion (37) latéraux sur le boîtier (31) pour la mise en contact électrique d'au moins un autre module d'interconnexion (1 1 ; 60 ; 80), **caractérisé en ce que** le boîtier (31) est conçu sous la forme d'un support de circuit (30) spatial, moulé par injection, du type de construction d'un Moulded Interconnect Devices (MID) et contient des pistes conductrices (29 ; 38 ; 39) sur lesquelles au moins un composant électrique (28) est disposé sur le support de circuit (30) pour une fonction de commande et/ou une fonction de surveillance et/ou une fonction de communication.

2. Module d'interconnexion selon la revendication 1, **caractérisé en ce que** les contacts d'interconnexion (37), à l'état monté en batterie des modules d'interconnexion, s'appliquent à plat les uns contre les autres.

3. Module d'interconnexion selon la revendication 1 ou 2, **caractérisé en ce que** les contacts d'interconnexion (37) sont formés par le boîtier (31) et/ou forment une partie constitutive intégrée du boîtier (31).

4. Module d'interconnexion selon l'une des revendications précédentes, **caractérisé en ce qu'**il comporte des pistes conductrices métalliques (29) appliquées par évaporation sous vide ou de manière galvanique, ou appliquées par estampage à chaud, ou des pistes conductrices (29) formées par au moins une pièce estampée et pliée (61) métallique intégrée.

5. Module d'interconnexion selon l'une des revendications précédentes, **caractérisé en ce que** les contacts d'interconnexion (37) à l'état monté en batterie sont recouverts vers l'extérieur.

6. Module d'interconnexion selon l'une des revendications précédentes, **caractérisé en ce que** les contacts d'interconnexion (37) sont disposés sur des faces opposées (42, 43) du module d'interconnexion (11; 60 ; 80) et sont reliés entre eux en particulier par des pistes conductrices (38, 39) continues.

7. Module d'interconnexion selon la revendication 6, **caractérisé en ce que** les pistes conductrices (38, 39) continues forment des surfaces de contact des contacts d'interconnexion (37).

8. Module d'interconnexion selon l'une des revendications précédentes, **caractérisé en ce qu'**il peut être relié à une unité de module (90) à commander et/ou à surveiller, le module d'interconnexion et l'unité de module (90) formant ensemble un module de batterie (10) qui peut être couplé à d'autres modules de batterie (10) en une batterie de modules (14).

9. Module d'interconnexion selon la revendication 8, **caractérisé en ce que** le au moins un composant électrique (28) est conçu pour la commande et/ou la surveillance de l'unité de module (90).

10. Module d'interconnexion selon la revendication 8 ou 9, **caractérisé en ce que** le au moins un composant électrique (28) est conçu pour une communication de l'unité de module (90) et/ou du module d'interconnexion avec d'autres modules de batterie (10) ou une commande de la batterie.

11. Module d'interconnexion selon la revendication 9 ou 10, **caractérisé en ce que** le au moins un composant électrique (28) est disposé sur au moins une piste conductrice (38, 39) continue, reliant deux contacts d'interconnexion (37) disposés sur des faces opposées (42, 43) du module d'interconnexion (11 ; 60 ; 80), et est relié électriquement à celles-ci.

12. Module d'interconnexion selon la revendication 9, 10 ou 11, **caractérisé en ce qu'**il comporte une chambre de réception (26) fermée à l'état monté, pour le au moins un composant électrique (28).

13. Module d'interconnexion selon l'une des revendications 8 à 12, **caractérisé en ce qu'**il comporte des moyens de liaison (48), en particulier des moyens de liaison par enfichage (50), pour la liaison électrique avec l'unité de module (90).

14. Module d'interconnexion selon la revendication 13, **caractérisé en ce que** les moyens de liaison (48) du module d'interconnexion (11 ; 60 ; 80) sont reliés à des moyens de liaison (49) coopérants de l'unité de module (90) à l'état monté, par une colle conductrice qui remplit en particulier un interstice existant sinon entre les moyens de liaison (48, 49) respectifs.

15. Module d'interconnexion selon l'une des revendications 8 à 14, **caractérisé en ce qu'**il est relié par adhérence de matière, en particulier soudé et/ou collé, à l'unité de module (90).

16. Module d'interconnexion selon l'une des revendications précédentes, **caractérisé en ce que** des contacts d'interconnexion (37), disposés sur une face (42, 43) respective du module d'interconnexion (11 ; 60 ; 80), sont groupés en une zone de contact (44 ; 45) pourvue en particulier d'un produit d'étanchéité assurant l'étanchéité vers l'extérieur.

17. Module d'interconnexion selon l'une des revendications précédentes, **caractérisé en ce que** les contacts d'interconnexion (37) sont formés par des éléments en matière plastique métallisés (46) ou par des contacts à ressort métalliques (63) ou par des contacts fuzzy (81).

18. Module d'interconnexion selon l'une des revendications précédentes, **caractérisé en ce que** pour la liaison électrique des contacts d'interconnexion (37) de modules d'interconnexion voisins, il est prévu des conducteurs disposés dans un corps isolant élastique, isolés électriquement les uns par rapport aux autres, à l'état monté le corps isolant électrique venant se placer entre les modules d'interconnexion voisins, et les conducteurs électriques reliant entre eux les contacts d'interconnexion des modules d'interconnexion.

19. Module d'interconnexion selon l'une des revendications précédentes, **caractérisé en ce que** les contacts d'interconnexion (37) contiennent des éléments en matière plastique métallisés (46) qui sont précontraints par un dispositif à ressort (47) métallique, pourvu en particulier d'un revêtement électriquement non conducteur, avec au moins un ressort et/ou un peigne à ressort métallique.

20. Module d'interconnexion selon l'une des revendications précédentes, **caractérisé en ce que** les contacts d'interconnexion (37) sont formés essentiellement par une structure de support fabriquée par un procédé de moulage par injection à deux composants, et **en ce qu'**à l'intérieur du module d'interconnexion (11 ; 60 ; 80) est réalisée une structure à pistes conductrices (29) sur un matériau activé au laser.

21. Module d'interconnexion selon l'une des revendications précédentes, **caractérisé en ce qu'**il comporte des moyens d'éclairage (33) pour l'indication d'au moins une fonction du module d'interconnexion (11 ; 60 ; 80).

22. Module d'interconnexion selon l'une des revendications précédentes, **caractérisé en ce qu'**il peut être couplé ou est relié de manière fixe à un dispositif fluidique à soupapes (13) et forme un ensemble de soupapes (10) qui peut être couplé à un ou plusieurs autres ensembles de soupapes (10) de ce type en une batterie de soupapes (14), et **en ce qu'**il contient une commande de soupape électrique (12) pour l'actionnement du dispositif fluidique à soupapes et/ou des moyens de liaison (48) pour une liaison électrique et une commande d'une commande de soupape électrique (12) pour l'actionnement du dispositif fluidique à soupapes.

23. Unité modulaire (90), en particulier ensemble de soupapes, ou batterie, en particulier batterie de soupapes (14), comportant au moins un module d'interconnexion (11 ; 60 ; 80) selon l'une des revendications précédentes.
